# EUROPEAN PATENT SPECIFICATION

(11) **EP 0 325 383 B1**
(45) Date of publication and mention of the grant of the patent: **06.10.1993**
(21) Application number: 89300335.0
(22) Date of filing: 13.01.1989
(51) Int. Cl.: H01L 29/80, H03F 3/70

(54) **Charge amplifier circuit comprising a junction field effect transistor**
Ladungsverstärkerschaltung mit Junction-Feldeffekttransistor
Circuit amplificateur de charge comprenant un transistor à effet de champ à jonction

(30) Priority: 16.01.1988 GB 8800949
(43) Date of publication of application: 26.07.1989
(73) Proprietor: LINK ANALYTICAL LIMITED, High Wycombe Bucks. HP12 3SE (GB)
(72) Inventor: Nashashibi, Tawfic Saeb, Egham Surrey (GB)
(74) Representative: Skone James, Robert Edmund

(56) References cited:
- US-A- 3 755 012
- US-A- 3 999 207
- I.E.E.E. TRANSACTIONS ON NUCLEAR SCIENCE, vol. NS-17, no. 1, February 1970, pages 269-275; V. RADEKA: "Overload recovery circuit for charge amplifiers"
- 18TH NUCLEAR SCIENCE SYMPOSIUM, San Francisco, 3rd - 5th November 1971, vol. NS-19, no. 1, February 1972, pages 403-411; E. ELAD: "Drain feedback - A novel feedback technique for low-noise cryogenic preamplifiers"

## Description

The present invention relates to charge amplifier circuits comprising a junction field effect transistor.

Junction field effect transistor (JFET) devices are used as charge amplifiers because they may be designed with a very high input impedance. Charge amplifiers are required to amplify the output from transducers of the type which produce small charge or current signals. Transducers of this type include, for example, those sensitive to ionising radiation such as gamma rays and x-rays. In x-ray flourescence equipment, for example, x-rays (generated by an x-ray tube or as a result of electron bombardment in an electron microscope) are analysed to determine the elemental composition of a specimen. Equipment of this type is disclosed in GB-A-2 208 431.

Usually, an FET is used as the first stage of a charge amplifier, which feeds other amplifier stages, to produce an amplified charge signal, which is in turn supplied to a processing unit. The processing unit is arranged to measure the charge signal to provide information relating to the conditions experienced by the transducer. Given that it is usual for the charge signal to change, increase say, in only one direction, the accumulated charge must be removed before the system starts to saturate and become non-linear; a process commonly known as a restore.

A problem with restoring charge amplifiers, as described above, is that the amount of accumulated charge is often very small, thus the required restore current may be a few nano amps required for less than ten micro seconds. The existance of stray capacitance in any electronic system makes direct control of a current this size virtually impossible, over such a small time scale.

A known solution to the problem of removing charge from amplifiers, of the aforesaid type, is that of "pulsed optical restore", as described in UK Patent No. 1153374. In this system, an accumulated charge is discharged by a light responsive semiconductor device, which in turn receives light from a light emitting semiconductor device. A short pulse of relatively high current, is directly applied to the light emitting device, however, the current generated by the light responsive device (positioned as close as possible to the accumulated charge to minimise the effect of stray capacitance) is several orders of magnitude smaller than the first current.

A problem with pulsed optical restore is that in many applicaions (including x-ray flourescence) light from the light emitting device must not reach the input transducer, x-ray detector say. However, shielding placed between the transducer and the light emitting device introduces capacitance. This problem is partially solved by arranging the light shield to be part of a feedback capacitance, however, opaque materials suitable for this application do not have good dielectric properties and introduce noise.

A further problem with pulsed optical restore, is that the light sensitive device introduces another stray capacitance. This problem may be overcome by designing the FET itself to be sensitive to light and then directing the restore light onto the FET. However, such an approach causes charge to build up on the FET and the additional time may be required to remove this charge, before measurements may be taken.

US-A-3999207 describes a semiconductor device having first, second and third semiconductive regions of alternating conductivity type in which the second semiconductive region is controlled by applying a voltage between the first and third regions and injecting carriers from one of those regions.

It is an object of the present invention to provide an improved charge amplifier circuit comprising a JFET. Charge amplifier circuits are known e.g. from IEEE NS-17, no. 1, pages 269-275 "Overload recovery circuit for charge amplifiers", V. Radeka.

According to the present invention, there is provided a charge amplifier circuit comprising a capacitance for storing charge from a transducer; a junction field effect transistor, said transistor having a substrate of a semiconducting material of a first conductivity type, a layer comprising a channel of a semiconducting material of a second conductivity type, a gate, a source, a drain and a region of said first conductivity type as an injector; means for supplying the stored output from said transducer to said gate; a threshold detector; means for supplying the output at said drain to said threshold detector, said threshold detector arranged to supply a pulse to said injector, when the drain output reaches a predetermined threshold, whereby carriers are injected into the channel of said junction field effect transistor to restore charge on said capacitance, via the gate of said transistor.

An advantage of the invention is that it provides an amplifier which does not require pulsed optical restore, thus, problems associated with irradiating the JFET itself are avoided. The optical properties of shielding, which forms part of the feedback capacitance, are no longer so important, thus materials such a PTFE, having good dielectric properties, may be used. Furthermore, the JFET may be positioned closer to the transducer, thus minimising the effect of capacitance in connecting wires. The combined effect of these advantages is to reduce noise, which in turn provides improved sensitivity.

Typically the gate is modified to said first type of semiconducting material and positioned between said source and said drain. The transistor is particularly suitable for amplifying charge or small currents.

The invention will now be described, by way of example only, with reference to the accompanying drawings of which:-
Figure 1 is a top view of a junction field effect transistor used in the present invention.
Figure 2 is a diagrammatic cross section of the transistor shown in Figure 1.
Figure 3 is a circuit diagram of an inventive charge amplifier based on the transistor shown in Figure 1.

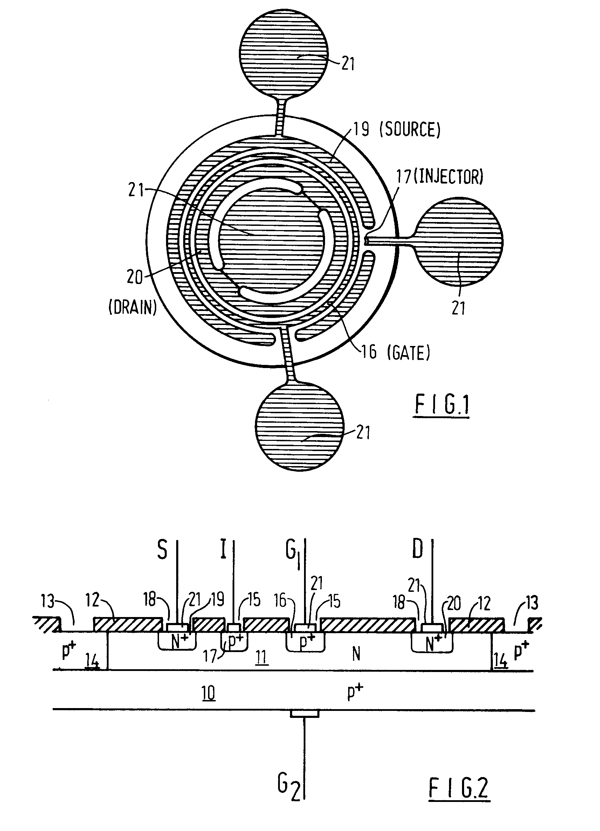

A top view of a junction field effect transistor is shown in Figure 1 and a diagrammatic cross section is shown in Figure 2. An N-channel device is shown but it could equally be a P-channel device:- all semiconductor regions being the opposite polarity to that shown.

A plurality of devices are formed on a substrate 10 of heavily doped (p+) silicon. An n-type epitaxial layer 11 is grown onto the substrate 10, to a thickness of five micro metres (forming the channel regions) which are covered by a passivation layer 12 of silicon dioxide. Windows 13 are opened in the oxide layer 12, by a process of photo lithography and etching, and the assembly is introduced to an atmosphere of boron at one thousand degrees C. Boron diffuses into the epitaxial layer forming isolation diffusion regions 14 which isolate each device from others formed on the substrate; the diffusion being deep enough to meet the substrate region 10.

After the isolation regions have been formed additional windows 15 are opened in the oxide layer and regions 16 and 17 of P+ type material are formed, either by boron diffusion or boron ion implantation. Region 16 provides a top gate in the form of a ciricular ring, as shown in Figure 1. Region 17 has been termed an injector and is a small region, positioned outside the ring of the gate region 16. The properties of the device, and in particular the effect of this region 17, are described below.

The device, which is referred to herein as an injector junction FET (IJFET), is completed in substantially the same way as a conventional JFET. Windows 15 are covered by growing another oxide layer and new windows 18 are opened. Phosphorus is diffused to form N+ regions for a source 19 (a ring surrounding the gate) and a drain 20, a ring inside the gate. The previously sealed windows 15 are reopened and a thin layer of aluminium is deposited onto the upper surface of the devices. Most of the aluminium is removed by photo lithography and etching to reveal bonding pads 21, connected to the source (S), gate (G1), drain (D) and injector (I) regions, onto which gold electrodes are connected. A second gate electrode (G2) is connected to the substrate 10, thus each individual device has a total of five electrodes.

The properties of the IJFET as a high impendance amplifier are not affected by the presence of the injector region until (for the n-channel device) a positive bias is applied to said injector. Thus, in a first mode operation, the device has a high input (gate) impedance and current flow (electrons for the n-channel device) from source to drain, is controlled in response to voltage applied to the gate (G1); the gate leakage current is negligable. In a second mode of operation a positive bias is applied to the injector (I) and a forward current passes through the junction between the p type injector 17 and the n-type layer 11. Holes are injected into the n-type layer which in turn allows a relatively small current to leak through the gate G1. Although small, compared to the injected current, the gate leakage current in this second mode is much larger than that experienced in the first mode. Thus any charge which may have built up on the input side of the device during its first mode of operation will be discharged during second mode operation, that is by applying a positive bias to the injector.

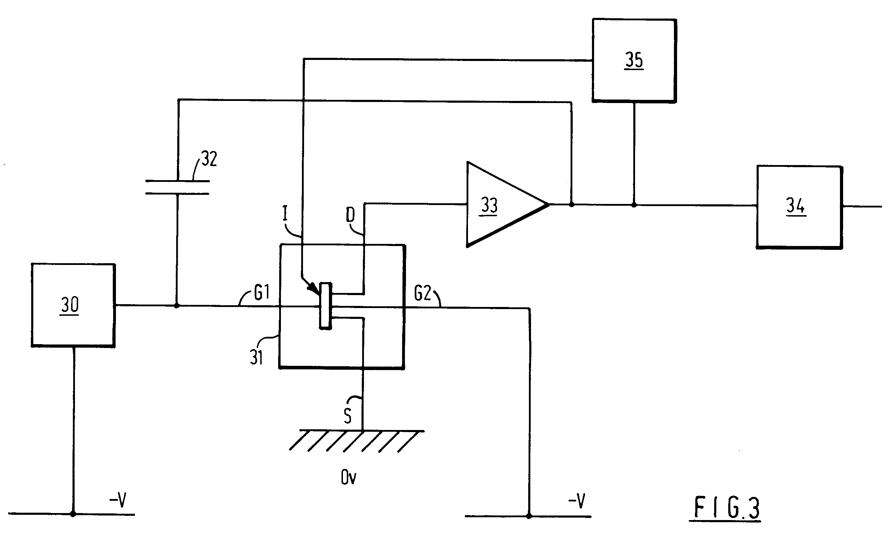

A charge amplifier according to the invention is shown in Figure 3 in which the output from a transducer 30, for example a silicon x-ray detector, is supplied to the gate of an IJFET 31. The symbol adopted for the IJFET is substantially the same as that for a standard dual gate JFET with the addition of an inclined arrow to identify the injector. Operation of the device in its second mode is similar to that of a PNP bipolar transistor, in which the injector 17 acts like an emitter, the gate region acts as a collector and the n-type layer (on the source side) acts as a base. The injector has therefore been identified in a manner commonly accepted for that of an emitter, the direction of the arrow being the direction of conventional current required to force the device to operate in its second mode.

The output charge from transducer 30 accumulates on a plate of a feedback capacitor 32, which in turn creates a proportionaly increasing drain current to be supplied to an amplifier 33. The output from amplifier 33 is supplied to a processing unit 34 and to a threshold detector 35. The processing unit 34 produces an output, which may be displayed, stored or processed further, by a computer or similar device. The threshold detector 35 supplies a predetermined current pulse to the injector I of the IJFET 31 when the amplified signal reaches a predetermined value. The magnitude and duration of the injector pulse is such that the accumulated charge on the capacitor 32 is restored by leakage through the gate G1 of the IJET31.

The IJFET allows a small restore current to be controlled by a much larger injector current without requiring pulsed optical restore. It has particular application in x-ray flourescence detectors in electron microscopes, gamma ray detectors and other systems in which small currents and charges are amplified.

## Claims

1. A charge amplifier circuit comprising a capacitance (32) for storing charge from a transducer (30); a junction field effect transistor, said transistor having a substrate (10) of a semiconducting material of a first conductivity type, a layer (11) comprising a channel of a semiconducting material of a second conductivity type, a gate (G1), a source (S), a drain (D) and a region (17) of said first conductivity type as an injector (I); means for supplying the stored ouput from said transducer (30) to said gate; a threshold detector (35); means for supplying the output at said drain (D) to said threshold detector (35), said threshold detector arranged to supply a pulse to said injector (I) when the drain output reaches a predetermined threshold whereby carriers are injected into the channel of said junction field effect transistor to restore charge on said capacitance via the gate of said transistor.

2. A charge amplifier circuit according to claim 1, wherein current flow between the source (S) and drain (D) is controllable in response to a voltage applied to the gate (G1), and injecting carriers via the injector (I) increases leakage currents through said gate (G1).

3. A charge amplifier circuit according to claim 2, wherein the substrate forms a second gate (G2).

4. A charge amplifier circuit according to any preceding claim wherein said gate (G1) comprises a region (16) within said layer (11) which is modified to said first conductivity type and positioned between said source (S) and said drain (D).

5. A charge amplifier circuit according to any preceding claim, wherein carriers are injected into said channel via an injector region (17) of said first conductivity type forming a junction with said layer (11).

6. A charge amplifier circuit according to claim 5, wherein the layer (11) is n-type material and the injector region (17) is heavily doped p+ type material.

7. A charge amplifier circuit according to claim 1, wherein the transducer is an x-ray detector arranged to examine x-rays generated in electron microscopes.

8. A charge amplifier circuit according to claim 7, which comprises an amplifier (33) to amplify the output from said drain before being applied to said threshold detector.

9. A charge amplifier circuit according to claim 8, which comprises a processing unit (34) to process said amplified drain output to determine the elemental make-up of a specimen examined under said electron microscope.

10. A method of amplifying charge signals or current signals, comprising the steps of storing said signals from a transducer (30) on a capacitance (32); supplying said stored signals to a gate of an injector junction field effect transistor (31), said transistor having a channel, a gate, a source, a drain and a region of conductivity opposite to said of a region in which said channel is formed as an injector; supplying an output from said drain to a threshold detector (35), wherein said threshold detector is arranged to supply a pulse to said injector when said drain output reaches a predetermined threshold, whereby carriers are injected into the channel of said transistor (31) to restore the charge on said capacitance (32) via the gate of said transistor.

## Patentansprüche

1. Ladungsverstärkerschaltung mit einer Kapazität (32) zur Speicherung von Ladung von einem Wandler (30), einem Junction-Feldeffekttransistor, der ein Substrat (10) aus einem Halbleitermaterial eines ersten Leitfähigkeitstyps, eine Schicht (11) mit einem Kanal aus einem Halbleitermaterial eines zweiten Leitfähigkeitstyps, einem Gate (G), einer Source (S), einem Drain (D) und einem Bereich (17) des ersten Leitfähigkeitstyps als Injektor (I) aufweist, einem Mittel zur Weitergabe des gespeicherten Ausgangs vom Wandler (30) zum Gate, einem Schwellwertdetektor (35), und einem Mittel zur Weiterleitung des Ausgangs am Drain (D) zum Schwellwertdetektor (35), wobei der Schwellwertdetektor einen Impuls zum Injektor (I) gibt, wenn der Drain-Ausgang einen vorbestimmten Schwellwert erreicht, wobei Ladungsträger in den Kanal des Junction-Feldeffekttransistors injiziert sind, um die Ladung auf der Kapazität über das Gate des Transistors wiederherzustellen.

2. Ladungsverstärkerschaltung nach Anspruch 1, wobei der Stromfluß zwischen Source (S) und Drain (D) mittels einer an das Gate (G1) angelegten Spannung steuerbar ist und die Injektion von Ladungsträgern über den Injektor (I) die Leckströme durch das Gate (G1) erhöht.

3. Ladungsverstärkerschaltung nach Anspruch 2, wobei das Substrat ein zweites Gate (G2) bildet.

4. Ladungsverstärkerschaltung nach einem der vorhergehenden Ansprüche, wobei das Gate (G1) innerhalb der Schicht (11) einen Bereich (16) aufweist, der zum ersten Leitfähigkeitstyp modifiziert und zwischen Source (S) und Drain (D) angeordnet ist.

5. Ladungsverstärkerschaltung nach einem der vorhergehenden Ansprüche, wobei Ladungsträger in den Kanal über einen Injektorbereich (17) des ersten Leitfähigkeitstyps injiziert werden und eine Übergangszone mit der Schicht (11) bilden.

6. Ladungsverstärkerschaltung nach Anspruch 5, wobei die Schicht (11) aus Material des n-Typs und der Injektorbereich (17) aus stark dotiertem Material des p+-Typs besteht.

7. Ladungsverstärkerschaltung nach Anspruch 1, wobei der Wandler ein Röntgenstrahlungsdetektor zur Untersuchung von in Elektronenmikroskopen erzeugter Röntgenstrahlung ist.

8. Ladungsverstärkerschaltung nach Anspruch 7, die einen Verstärker (33) aufweist, der den Ausgang des Drains vor Anwendung auf einen Schwellwertdetektor verstärkt.

9. Ladungsverstärkerschaltung nach Anspruch 8, die eine Verarbeitungseinheit (34) zur Verarbeitung des verstärkten Drain-Ausgangs aufweist zur Bestimmung der elementaren Zusammensetzung einer unter einem Elektronenmikroskop untersuchten Probe.

10. Verfahren zur Verstärkung von Ladungssignalen oder Stromsignalen, mit den Schritten Speichern eines Signals von einem Wandler (30) in einer Kapazität (32), Zuführung des gespeicherten Signals zur einem Gate eines Injektor-Junction-Feldeffekttransistors (31) mit einem Kanal, einem Gate, einer Source, einem Drain und einem Leitfähigkeitsbereich mit entgegengesetzter Leitfähigkeit zu dem Bereich, in dem der Kanal als Injektor gebildet ist, Zuführung eines Ausgangs vom Drain zu einem Schwellwertdetektor (35), wobei der Schwellwertdetektor zur Zuführung eines Impulses zum Injektor ausgebildet ist, wenn der Drain-Ausgang einen vorbestimmten Schwellwert erreicht hat, wobei Ladungsträger in den Kanal des Transistors (31) injiziert werden, um die Ladung auf der Kapazität (32) über das Gate des Transistors wiederherzustellen.

## Revendications

1. Circuit amplificateur de charge comprenant un condensateur (32) pour emmagasiner la charge provenant d'un transducteur (30) ; un transistor à effet de champ à jonction, ledit transistor comportant un substrat (10) fait d'une matière semi-conductrice d'un premier type de conductivité, une couche (11), comprenant un canal, faite d'une matière semi-conductrice d'un second type de conductivité, une grille (G1), une source (S), un drain (D) et, comme injecteur (I), une région (17) dudit premier type de conductivité ; un moyen pour délivrer la sortie emmagasinée dudit transducteur (30) à ladite grille ; un détecteur à seuil (35) ; un moyen pour délivrer la sortie dudit drain (D) audit détecteur à seuil (35), ledit détecteur à seuil étant disposé pour délivrer une impulsion audit injecteur (I) lorsque la sortie de drain atteint un seuil prédéterminé ce par quoi des porteurs sont injectés dans le canal dudit transistor à effet de champ à jonction pour reconstituer la charge dudit condensateur par l'intermédiaire de la grille dudit transistor.

2. Circuit amplificateur de charge selon la revendication 1, dans lequel l'écoulement de courant entre la source (S) et le drain (D) peut être commandé en réponse à une tension appliquée à la grille (G1), et dans lequel l'injection de porteurs par l'injecteur (I) augmente les courants de fuite à travers ladite grille (G1).

3. Circuit amplificateur de charge selon la revendication 2, dans lequel le substrat forme une seconde grille (G2).

4. Circuit amplificateur de charge selon l'une quelconque des revendications précédentes, dans lequel ladite grille (G1) comprend une région (16) à l'intérieur de ladite couche (11) qui est modifiée en ledit premier type de conductivité et qui est située entre ladite source (S) et ledit drain (D).

5. Circuit amplificateur de charge selon l'une quelconque des revendications précédentes, dans lequel des porteurs sont injectés dans ledit canal par l'intermédiaire d'une région injecteur (17) dudit premier type de conductivité formant une jonction avec ladite couche (11).

6. Circuit amplificateur de charge selon la revendication 5, dans lequel la couche (11) est une matière de type n et la région d'injecteur (17) est une matière de type p⁺ lourdement dopée.

7. Circuit amplificateur de charge selon la revendication 1, dans lequel le transducteur est un détecteur de rayons X agencé pour examiner des rayons X produits dans des microscopes électroniques.

8. Circuit amplificateur de charge selon la revendication 7, qui comprend un amplificateur (33) pour amplifier la sortie issue dudit drain avant qu'elle soit appliquée audit détecteur à seuil.

9. Circuit amplificateur de charge selon la revendication 8, qui comprend une unité de traitement (34) pour traiter ladite sortie de drain amplifiée pour déterminer la constitution élémentaire d'un échantillon examiné sous ledit microscope électronique.

10. Procédé d'amplification de signaux de charge ou de signaux de courant, comprenant les étapes d'emmagasinage desdits signaux issus d'un transducteur (30) sur un condensateur (32), de délivrance desdits signaux emmagasinés à une grille d'un transistor à effet de champ à jonction à injecteur (31), ledit transistor ayant un canal, une grille, une source, un drain et, comme injecteur, une région de conductivité opposée à celle d'une région dans laquelle ledit canal est formé ; délivrance d'une sortie dudit drain à un détecteur à seuil (35), dans lequel ledit détecteur à seuil est conçu pour délivrer une impulsion audit injecteur lorsque ladite sortie de drain atteint un seuil prédéterminé, ce par quoi des porteurs sont injectés dans le canal dudit transistor (31) pour reconstituer la charge dudit condensateur (32) par l'intermédiaire de la grille dudit transistor.
